# FASCICULE DE BREVET EUROPEEN

(11) **EP 1 656 562 B1**
(45) Date de publication et mention de la délivrance du brevet: **28.06.2017**
(21) Numéro de dépôt: 04786320.4
(22) Date de dépôt: 18.08.2004
(51) Int. Cl.: G01R 29/08

(54) **DISPOSITIF DE CONTROLE DU DEBIT D'ABSORPTION SPECIFIQUE D'OBJETS RAYONNANTS FABRIQUES EN SERIE**
VORRICHTUNG ZUR KONTROLLE DER SPEZIFISCHEN ABSORBTIONSRATE VON STRAHLENDEN MASSENPRODUKTIONSOBJEKTEN
DEVICE FOR CONTROLLING THE SPECIFIC ABSORPTION RATE OF MASS-PRODUCED RADIANT OBJECTS

(30) Priorité: 18.08.2003 FR 0309994
(43) Date de publication de la demande: 17.05.2006
(73) Titulaire: Microwave Vision, 91140 Villebon Sur Yvette (FR)
(72) Inventeur: GARREAU, Philippe, F-91540 Mennecy (FR); DUCHESNE, Luc, F-91470 Angervilliers (FR); BOLOMEY, Jean-Charles, F-75013 Paris (FR)
(74) Mandataire: Regimbeau
(86) Numéro de dépôt international: PCT/FR2004/002154
(87) Numéro de publication internationale: WO 2005/019843

(56) Documents cités:
- WO-A-01/75460
- WO-A1-02/056041
- WO-A2-01/81932
- JP-A- 2003 087 207
- US-A- 5 440 316
- US-A- 6 021 315

## Description

La présente invention est relative au contrôle du débit d'absorption spécifique, également appelé DAS ou SAR (« specific absorption rate » selon la terminologie anglo-saxonne généralement utilisée) d'objets rayonnants fabriqués en série et notamment de téléphones portables.

On sait que le niveau d'exposition aux ondes électromagnétiques des usagers de téléphones portables est fixé par des normes qui généralement définissent le SAR maximum acceptable pour une masse de tissu biologique donné.

Il existe notamment des normes en ce sens en Europe, aux Etats-Unis et au Japon.

Or, les procédures de mesures qui sont définies par ces normes sont relativement complexes et fastidieuses à mettre en oeuvre.

Généralement, ces normes prévoient que le SAR maximum intégré, noté ou <SAR>, est calculé à partir d'une pluralité de mesures de champ électrique dans un fantôme homogène reproduisant des conditions très voisines de celles des milieux biologiques correspondant au corps humain.

Ainsi, par exemple en Europe, le volume exploré est environ un cube de 2 cm de côté et le pas d'échantillonnage est de quelques millimètres, de sorte que le nombre de mesures à effectuer est de l'ordre de plusieurs centaines. Ces mesures doivent en outre être répétées pour au moins deux positions du téléphone portable par rapport au fantôme, d'un côté et de l'autre de celui-ci, ainsi que pour au moins trois fréquences (ou six pour les portables bi-bandes).

On connaît du document WO 0175460 un dispositif de test de la puissance de rayonnement d'un objet sous test de type téléphone. Ce dispositif comprend une chambre dans laquelle l'objet sous test est placé à demeure et une antenne reliée à une unité de mesure de la puissance pour mesurer le rayonnement émis par ledit objet. De plus, le document WO 02/056041 A1 divulgue le contrôle rapide du débit d'absorption spécifique dans le corps humain des téléphones portables. Pour finir, les documents JP 2003 087207 et WO 01 /081932 A2 divulguent l'utilisation d'une sonde qui est plongée dans un matériau du fantôme afin d'estimer le débit d'absorption spécifique.

On comprend donc que les protocoles proposés par ces documents normatifs sont particulièrement longs et qu'il n'est pas envisageable de tester de cette façon tous les téléphones portables qui peuvent être mis sur le marché.

Il existe donc un besoin pour un test permettant de contrôler rapidement ces téléphones portables en fin de fabrication.

A cet effet, l'invention propose un dispositif pour le contrôle du débit d'absorption spécifique d'objets rayonnants fabriqués en série, caractérisé en ce qu'il comporte au moins un capteur pour la mesure d'une puissance rayonnée par un objet situé au niveau de ladite zone et au moins une unité de traitement qui analyse la puissance ainsi mesurée, le capteur comportant un guide d'ondes présentant une ouverture disposée en regard de la zone de test et au moins une sonde de mesure disposée à l'intérieur dudit guide d'ondes.

Un tel dispositif est avantageusement complété par les différentes caractéristiques suivantes prises seules ou selon toutes leurs combinaisons techniquement possibles :
- il comporte des moyens pour le convoyage des objets jusqu'à la zone de test.
- le capteur comporte en outre un fantôme en un matériau ayant des propriétés diélectriques similaires à celles de tissus biologiques, dans lequel le guide d'ondes est plongé.
- le fantôme est de forme cylindrique ou plus complexe.
- le guide d'ondes est de section rectangulaire ou circulaire, éventuellement variable pour former un cornet.
- le capteur comporte au moins deux sondes orthogonales placées à l'intérieur du guide d'ondes.
- le guide d'ondes comporte deux paires de sondes orthogonales.
- les deux paires de sondes sont reliées à des moyens de traitement, permettant notamment la mise en oeuvre d'écartométrie.
- l'unité de traitement commande l'affichage sur un écran d'une courbe dont l'amplitude et l'étendue sont fonction de la puissance rayonnée mesurée par le capteur et dont la position est fonction des mesures d'écartométrie.
- le dispositif comporte un réseau de plusieurs capteurs présentant différentes orientations.
- dans le cas où les objets rayonnants sont des terminaux de communication cellulaires, il comporte en amont de la zone de test un simulateur de station de base.
- le dispositif comporte en amont du ou des capteurs des moyens de guidage aptes à imposer un certain positionnement aux objets rayonnants.
- l'unité de traitement mémorise des correspondances entre des valeurs de débits d'absorption spécifiques intégrés et des valeurs de puissances électriques, ces correspondances étant déterminées préalablement par calibration.

Avantageusement également, on met en oeuvre des tests en cours ou en fin de fabrication en prélevant de la chaîne de fabrication des objets que l'on analyse dans un container blindé et anéchoïque contenant un capteur ou un réseau de capteurs à guides d'onde et sondes de mesure.

D'autres caractéristiques et avantages de l'invention ressortiront encore de la description qui suit, laquelle est purement administrative et non limitative et doit être 5 lue en regard des dessins annexés sur lesquels :
La figure 1 illustre une zone de test équipée d'un dispositif conforme à un mode de réalisation possible de l'invention.
La figure 2 illustre schématiquement un exemple de capteur possible.
La figure 3 illustre schématiquement un autre exemple de capteur possible.
La figure 4 illustre l'utilisation d'une pluralité de capteurs répartis en arche.
Les figures 5a et 5b sont des représentations schématiques en coupe transversale de capteurs à quatre sondes dans le cas d'une part d'un capteur à guide d'ondes de section circulaire (figure 5a) et d'autre part d'un capteur à guide d'ondes de section carrée (figure 5b).
La figure 6 est un schéma illustrant le principe d'un montage d'écartométrie réalisé avec un capteur à quatre sondes.

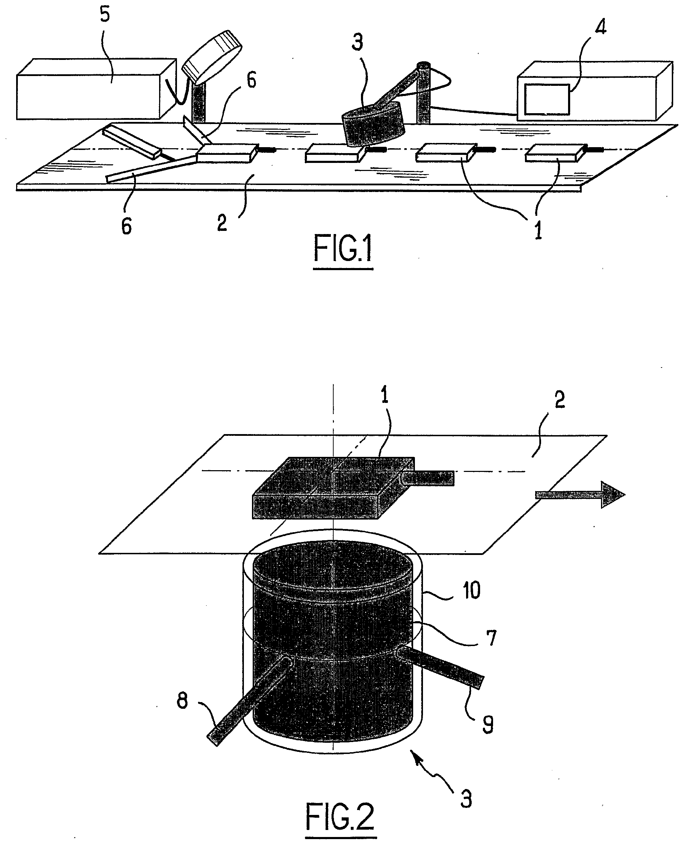

On a représenté sur la figure 1 une zone qui est disposée par exemple à la fin d'une ligne production de téléphones portables 1 et qui est équipée d'un dispositif permettant de tester le SAR intégré des téléphones fabriqués.

Les téléphones portables 1 y sont transportés sur une bande de convoyage 2 qui leur fait traverser ladite zone de test.

Cette zone de test comporte notamment un ou plusieurs capteur(s) 3 qui sont disposés en regard ou près de la bande de convoyage 2, au dessus et/ou en dessous de celle-ci, et qui permettent la mesure du SAR intégré. Le ou les capteurs 3 sont reliés à une unité de traitement 4. Ils sont disposés, par rapport au sens d'entraînement de la bande de convoyage 2, en aval d'un simulateur de station de base 5.

Le rôle du simulateur 5 est d'activer les téléphones portables 1 qui arrivent dans la zone de test pour qu'ils se retrouvent dans un état où ils émettent leur puissance maximale Pmax lorsqu'ils se trouvent au niveau de la zone de test et qu'ils passent devant le ou les capteurs 3.

Des rampes de guidage 6 sont disposées juste au dessus de la bande de convoyage 2, en amont de la zone de test, et permettent de forcer les téléphones portables à s'orienter de façon prédéfinie, par exemple de manière à ce que leur axe longitudinal coïncide sensiblement avec l'axe le long duquel ils sont entraînés par ladite bande de convoyage 2 lorsqu'ils se trouvent dans la zone de test.

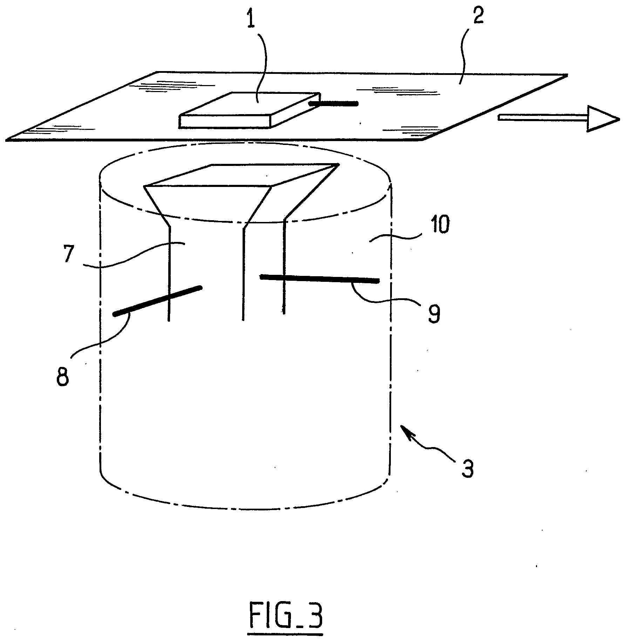

Un exemple de capteur 3 va maintenant être plus précisément décrit en référence aux figures 2 et 3.

Ce capteur 3 comporte une structure métallique 7 qui définit un guide d'ondes qui est apte à guider les ondes électromagnétiques pour contrôler leur propagation jusqu'à au moins deux sondes de détection orthogonales 8 et 9, qui permettent de mesurer le champ électrique dans deux directions de polarisation.

Le champ électrique ainsi mesuré est transmis à l'unité de traitement 4 qui détermine la puissance électrique qui correspond au champ ainsi mesuré selon deux directions de polarisation. On peut imaginer une procédure simplifiée dans laquelle on se contente de mesurer la composante prédominante du champ électrique dont l'état de polarisation aura été analysé préalablement. Dans ce cas il suffit de mesurer cette seule composante du champ par une orientation convenable du capteur.

Dans le cas illustré sur la figure 2, le guide d'ondes 7 est de forme cylindrique.

Avantageusement également, ainsi que l'illustre la figure 3, ce guide d'ondes 7 peut être un guide d'ondes en cornet, de façon à permettre de confiner les ondes tout en permettant une intégration sur une surface d'entrée maximale.

Ce guide d'onde 7, qu'il soit cylindrique, en forme de cornet ou autre, est plongé dans un matériau remplissant un fantôme 10 dont les propriétés diélectriques correspondent à celles de tissus biologiques.

Le matériau est avantageusement un liquide équivalent.

Le fantôme est par exemple de forme comparable à celles qui sont habituellement proposées dans les documents normatifs (fantômes génériques de forme simple (sphères notamment) ou anthropomorphiques).

Par exemple, il peut être comme illustré sur les figures 2 et 3, de forme cylindrique.

Dans ce cas, on gagne en encombrement, en complexité de réalisation et en coût.

On notera à cet égard qu'un encombrement réduit permet la constitution de réseaux de sondes juxtaposées.

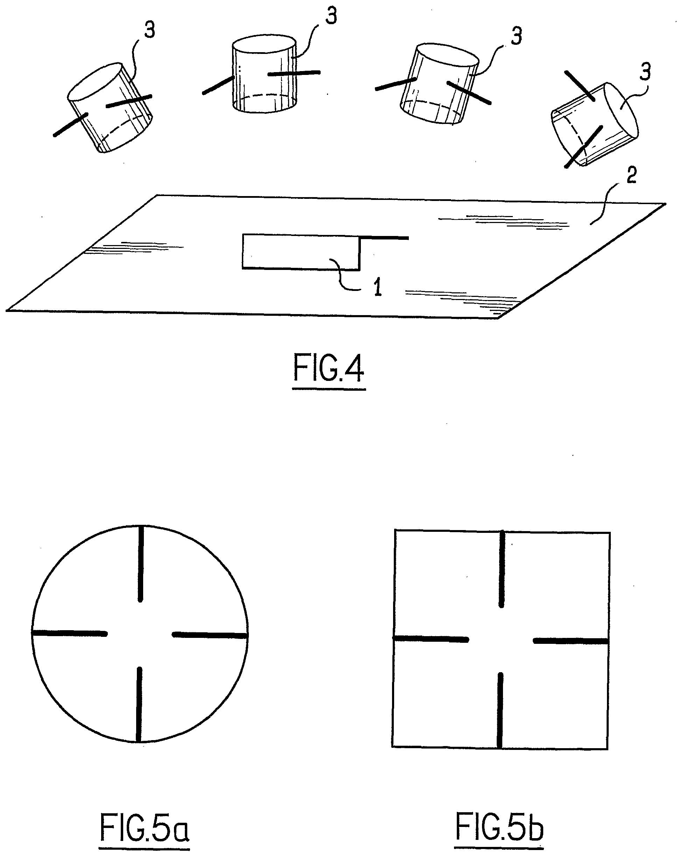

C'est le cas de figure qu'illustre la figure 4 sur laquelle on a représenté un réseau de capteurs 3 disposés en arche autour de la zone dans laquelle passent les téléphones portables 1.

Un tel réseau de sondes en arche permet de tolérer une certaine absence dispersion d'alignement des téléphones portables par rapport à l'axe principal de déplacement du tapis et de varier les configurations de test.

On notera que le guide d'ondes 7 d'un capteur du type de ceux illustrés sur les figures 2 et 3 est disposé à une distance assez proche des antennes des téléphones portables comme en test standard, typiquement de l'ordre de quelques mm à quelques cm.

Par ailleurs, un tel capteur 3 comporte avantageusement, ainsi que l'illustrent les figures 5a et 5b, non pas deux sondes mais quatre sondes orthogonales. L'utilisation de quatre sondes ou antennes permet, en effet, des mesures écartométriques permettant d'apporter des informations sur la localisation et l'étendue de la zone ou « spot » de dissipation, de puissance dans le fantôme.

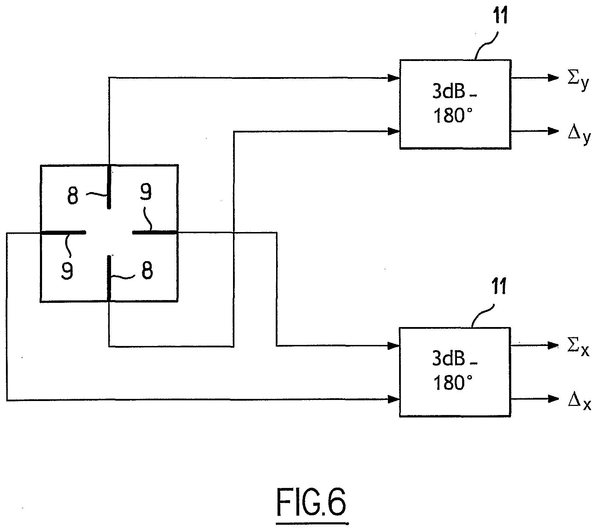

On utilise à cet effet avantageusement, ainsi que l'illustre la figure 6, des coupleurs 3dB - 180° (référencés par 11) permettant de calculer les sommes et différences des amplitudes de champ mesuré par les sondes selon d'une part un premier axe (axe X) et d'autre part un deuxième axe (axe Y). Ces signaux somme et différence sont eux-mêmes envoyés à l'unité de traitement 4 où ils sont analysés pour en déduire le SAR et des informations complémentaires sur la position et ou l'orientation du téléphone portable 1 ainsi que sur de possibles dysfonctionnements.

En effet, cette mesure écartométrique permet un contrôle de position des téléphones sous test et peut s'avérer utile dans le diagnostic apporté à une éventuelle différence entre les mesures observées sur un téléphone et les mesures de référence auxquelles celui-ci devrait correspondre. Elle apporte également une meilleure appréciation de l'étendue sur laquelle la puissance est répartie.

Il est avantageusement prévu en outre que l'unité de traitement 4 affiche sur un écran une tache dont l'intensité et l'étendue sont fonction de la puissance électrique mesurée et dont la position sera celle déduite des intensités des courbes d'écartométrie.

Les informations de mesure de champ intégré, mesuré avec le dispositif qui vient d'être décrit sont avantageusement utilisées pour en déduire, en utilisant les des tables de correspondance pré mémorisées, les <SAR> intégrés des téléphones portables analysés.

On utilise à cet effet préalablement des procédures de calibrage permettant de mettre en correspondance des mesures de champ effectuées par le capteur et des SAR intégrés de téléphone portable tels que mesurés dans un banc de mesure normalisé.

Le <SAR> est en effet très étroitement corrélé à la puissance dissipée dans le fantôme, laquelle dépend essentiellement du fantôme utilisé (forme, dimensions, caractéristiques diélectriques, etc.), du téléphone portable (type d'antenne, couplage du boîtier, ...), de la position relative du portable par rapport au fantôme.

L'utilisation d'un capteur à guide d'ondes permet d'intégrer le flux de puissance à travers son ouverture et de réaliser de cette façon une mesure globale de la puissance dissipée dans le fantôme, laquelle pour un type de téléphone et de fantôme donnés pour une position relative du téléphone par rapport au fantôme peut être directement reliée, par une table de correspondance, à une valeur de <SAR>.

On notera également que le dispositif peut être également placé dans un container blindé et anéchoïque contenant un capteur ou un réseau de capteurs à guides d'onde et sondes de mesure. Un tel container permet de mettre en oeuvre des tests en prélevant des objets de la chaîne de fabrication.

Il peut être utilisé seul ou en compléments de capteurs disposés au droit de la chaîne de convoyage, par exemple en vue d'un test approfondi.
Ce dispositif de test qui vient d'être décrit présente de nombreux avantages.

Il permet une procédure de test rapide (plusieurs téléphones par minutes).

Il permet de disposer en temps réel d'une indication de conformité et/ou d'une estimation de <SAR> permettant un tri sur les objets rayonnants (téléphones ou autres) fabriqués et éventuellement une indication de diagnostic en vue d'un éventuel recyclage.

Il est faible coût.

Il est non invasif.

Il est facile à intégrer dans une ligne de production.

Il nécessite un nombre de sondes réduit, typiquement 2 à 4.

## Revendications

1. Dispositif pour le contrôle du débit d'absorption spécifique d'objets rayonnants fabriqués en série, comportant au moins un capteur pour la mesure d'une puissance rayonnée par un objet situé au niveau de la zone de test et au moins une unité de traitement qui analyse la puissance ainsi mesurée, le capteur comportant un guide d'ondes présentant une ouverture disposée en regard de la zone de test et au moins une sonde de mesure disposée à l'intérieur dudit guide d'ondes, le dispositif comportant en outre des moyens pour le convoyage des objets jusqu'à la zone de test,
ledit dispositif étant **caractérisé en ce que** le capteur comporte en outre un fantôme en un matériau ayant des propriétés diélectriques similaires à celles de tissus biologiques, dans lequel le guide d'ondes est plongé.

2. Dispositif selon l'une des revendications précédentes, **caractérisé en ce que** le fantôme est de forme cylindrique ou plus complexe.

3. Dispositif selon l'une des revendications précédentes, **caractérisé en ce que** le guide d'ondes est de section rectangulaire ou circulaire ou plus complexe.

4. Dispositif selon l'une des revendications précédentes, **caractérisé en ce que** le guide d'ondes est un cornet.

5. Dispositif selon l'une des revendications précédentes, **caractérisé en ce qu'**il comporte au moins deux sondes orthogonales qui s'étendent à l'intérieur du guide d'ondes.

6. Dispositif selon la revendication 5 **caractérisé en ce que** le guide d'ondes comporte deux paires de sondes orthogonales pour traitement écartométrique.

7. Dispositif selon la revendication 6, **caractérisé en ce que** les deux paires de sondes sont reliées à des moyens d'écartométrie.

8. Dispositif selon la revendication 7, **caractérisé en ce que** l'unité de traitement commande l'affichage sur un écran d'une courbe dont l'amplitude et l'étendue sont fonction de la puissance rayonnée mesurée et dont la position est fonction des mesures d'écartométrie.

9. Dispositif selon l'une des revendications précédentes, **caractérisé en ce qu'**il comporte un réseau de plusieurs capteurs présentant différentes orientations.

10. Dispositif selon l'une des revendications précédentes **caractérisé en ce que**, dans le cas où les objets rayonnants sont des terminaux de communication cellulaires, il comporte en amont de la zone de test un simulateur de station de base.

11. Dispositif selon l'une des revendications précédentes, **caractérisé en ce qu'**il comporte en amont du ou des capteurs des moyens de guidage aptes à imposer un certain positionnement aux objets rayonnants.

12. Dispositif selon l'une des revendications précédentes, **caractérisé en ce que** l'unité de traitement mémorise des correspondances entre des valeurs de débits d'absorption spécifiques intégrés et des valeurs de puissances électriques, ces correspondances étant déterminées préalablement par calibration.

13. Dispositif selon l'une des revendications précédentes, **caractérisé en ce qu'**il comporte un container blindé et anéchoïque contenant un capteur ou un réseau de capteurs à guides d'onde et sondes de mesure.

## Patentansprüche

1. Verfahren zur Kontrolle der spezifischen Absorptionsrate von in Serie hergestellten strahlenden Gegenständen, umfassend mindestens einen Sensor zur Messung einer Leistung, abgestrahlt von einem Gegenstand, der sich auf der Ebene des Testbereichs befindet, und mindestens eine Behandlungseinheit, die die so gemessene Leistung analysiert, wobei der Sensor einen Wellenleiter umfasst, der eine Öffnung aufweist, die gegenüber dem Testbereich angeordnet ist, und mindestens eine Messsonde, die im Inneren des Wellenleiters angeordnet ist, wobei die Vorrichtung außerdem Mittel umfasst, um Gegenstände bis zum Testbereich zu befördern,
wobei die Vorrichtung **dadurch gekennzeichnet ist, dass** der Sensor außerdem ein Phantom aus einem Material umfasst, das dielektrische Eigenschaften aufweist, die ähnlich denjenigen von biologischen Geweben sind, in das der Wellenleiter getaucht ist.

2. Vorrichtung nach einem der vorhergehenden Ansprüche, **dadurch gekennzeichnet, dass** das Phantom eine zylindrische oder komplexere Form aufweist.

3. Vorrichtung nach einem der vorhergehenden Ansprüche, **dadurch gekennzeichnet, dass** der Wellenleiter einen rechtwinkligen oder kreisförmigen oder komplexeren Schnitt aufweist.

4. Vorrichtung nach einem der vorhergehenden Ansprüche, **dadurch gekennzeichnet, dass** der Wellenleiter ein Kornett ist.

5. Vorrichtung nach einem der vorhergehenden Ansprüche, **dadurch gekennzeichnet, dass** sie mindestens zwei orthogonale Sonden umfasst, die sich im Inneren des Wellenleiters erstrecken.

6. Vorrichtung nach Anspruch 5, **dadurch gekennzeichnet, dass** der Wellenleiter zwei Paar orthogonale Sonden zur Abstandsmessbehandlung umfasst.

7. Vorrichtung nach Anspruch 6, **dadurch gekennzeichnet, dass** die zwei Paar Sonden mit Abstandsmessmitteln verbunden sind.

8. Vorrichtung nach Anspruch 7, **dadurch gekennzeichnet, dass** die Behandlungseinheit die Anzeige einer Kurve auf einem Bildschirm steuert, dessen Amplitude und Umfang eine Funktion der gemessenen gestrahlten Leistung ist, und dessen Position eine Funktion der Abstandsmessungen ist.

9. Vorrichtung nach einem der vorhergehenden Ansprüche, **dadurch gekennzeichnet, dass** sie ein Netz aus mehreren Sensoren umfasst, die verschiedene Ausrichtungen aufweisen.

10. Vorrichtung nach einem der vorhergehenden Ansprüche, **dadurch gekennzeichnet, dass**, für den Fall, dass die strahlenden Gegenstände zelluläre Kommunikationsendgeräte sind, sie vorgelagert vom Testbereich einen Basisstation-Simulator umfasst.

11. Vorrichtung nach einem der vorhergehenden Ansprüche, **dadurch gekennzeichnet, dass** sie vorgelagert von dem oder den Sensoren Führungsmittel umfasst, die ausgelegt sind, um den strahlenden Gegenständen eine bestimmte Positionierung aufzuerlegen.

12. Vorrichtung nach einem der vorhergehenden Ansprüche, **dadurch gekennzeichnet, dass** die Behandlungseinheit Entsprechungen zwischen integrierten spezifischen Absorptionsratenwerten und elektrische Leistungswerte speichert, wobei diese Entsprechungen im Voraus durch Kalibrierung bestimmt werden.

13. Vorrichtung nach einem der vorhergehenden Ansprüche, **dadurch gekennzeichnet, dass** sie einen gepanzerten und reflexionsarmen Behälter umfasst, der einen Sensor oder ein Netz von Sensoren mit Wellenleiter und Messsonden enthält.

## Claims

1. Device for controlling the specific absorption rate of mass-produced radiant objects, comprising at least one sensor for measuring a power radiated by an object which is located in the test zone and at least one processing unit for analysing the power thus measured, with the sensor comprising a waveguide having an opening arranged opposite the test zone and at least one measuring probe arranged inside said waveguide, with the device further comprising means for conveying objects to the test zone,
said device **characterised in that** the sensor further comprises a phantom made of a material that has dielectric properties similar to those of biological tissues, wherein the waveguide is plunged.

2. Device according to one of the preceding claims, **characterised in that** the phantom is of a cylindrical or more complex shape.

3. Device according to one of the preceding claims, **characterised in that** the waveguide has a rectangular or circular or more complex section.

4. Device according to one of the preceding claims, **characterised in that** the waveguide is a cornet.

5. Device according to one of the preceding claims, **characterised in that** it comprises at least two orthogonal probes that extend inside the waveguide.

6. Device according to claim 5 **characterised in that** the waveguide comprises two pairs of orthogonal probes for offsetting treatment.

7. Device according to claim 6, **characterised in that** the two pairs of probes are connected to means for offsetting.

8. Device according to claim 7, **characterised in that** the processing unit controls the display on a screen of a curve of which the amplitude and the extent are according to the radiated power measured and of which the position is according to offsetting measurements.

9. Device according to one of the preceding claims, **characterised in that** it comprises a network of several sensors having different orientations.

10. Device according to one of the preceding claims **characterised in that**, in the case where the radiant objects are cellular communication terminals, it comprises a base station simulator upstream of the test zone.

11. Device according to one of the preceding claims, **characterised in that** it comprises upstream of the sensor or sensors means for guiding able to impose a certain positioning on the radiant objects.

12. Device according to one of the preceding claims, **characterised in that** the processing unit memorises correspondences between the values of integrated specific absorption flow rates and values of electric powers, with these correspondences being determined beforehand by calibration.

13. Device according to one of the preceding claims, **characterised in that** it comprises a shielded and anechoic container containing a waveguide sensor or a network of sensors and measuring probes.
